# EUROPEAN PATENT APPLICATION

(11) **EP 2 680 323 A1**
(43) Date of publication of application: **01.01.2014**
(21) Application number: 13171545.0
(22) Date of filing: 11.06.2013
(51) Int. Cl.: H01L 33/00, H01L 21/683

(54) **Method for manufacturing a light-emitting diode (LED)**

(30) Priority: 28.06.2012 JP 2012145449
(71) Applicant: NITTO DENKO CORPORATION, Ibaraki-shi, Osaka 567-8680 (JP)
(72) Inventor: Takahashi, Tomokazu, Ibaraki-shi, Osaka 567-8680 (JP); Akizuki, Shinya, Ibaraki-shi, Osaka 567-8680 (JP); Sugimura, Toshimasa, Ibaraki-shi, Osaka 567-8680 (JP); Matsumura, Takeshi, Ibaraki-shi, Osaka 567-8680 (JP); Uenda, Daisuke, Ibaraki-shi, Osaka 567-8680 (JP)
(74) Representative: Gill, Stephen Charles

(57) **Abstract**

A method of manufacturing an LED according to an embodiment of the present invention includes back-grinding a substrate of an LED wafer including a light emitting element and the substrate,
wherein the back-grinding includes fixing the LED wafer to a table via a double-sided pressure-sensitive adhesive sheet, and then grinding the substrate.

## Description

### BACKGROUND OF THE INVENTION

### 1. Field of the Invention

The present invention relates to a method of manufacturing an LED.

### 2. Description of the Related Art

Hitherto, in manufacture of an LED, a light emitting element is laminated on a substrate to form an LED wafer, and then a surface of the substrate on a side opposite to the light emitting element is ground (back-ground) to thin the substrate (for example, Japanese Patent Application Laid-open Nos. 2005-150675 and 2002-319708). Generally, this grinding is carried out while fixing a surface of the substrate on the light emitting element side to a table via a pressure-sensitive adhesive wax. The LED wafer that has undergone grinding is subjected to, for example, steps of heating the wax to release the LED wafer, cleaning the wax adhering on the LED wafer, cutting (dicing) the LED wafer to singulate small element pieces, and forming a reflective layer on the surface of the substrate on the side opposite to the light emitting element.

The above-mentioned back-grinding step is a step of grinding the LED wafer to be very thin. Therefore, during the grinding, there is a problem in that damage such as cracking easily occurs in the LED wafer. In addition, there are such problems that man-hours are required to apply and clean the wax, and that the environmental load is large because a solvent is used to clean the wax. Moreover, there is a problem in that the LED is negatively affected by cleaning liquid.

### SUMMARY OF THE INVENTION

The present invention has been made to address the above-mentioned conventional problem, and has an object to provide a method of manufacturing an LED with a small environmental load, which is simple and capable of manufacturing an LED with high yields by preventing damage to the LED wafer.

A method of manufacturing an LED according to an embodiment of the present invention includes back-grinding a substrate of an LED wafer including a light emitting element and the substrate,
wherein the back-grinding includes fixing the LED wafer to a table via a double-sided pressure-sensitive adhesive sheet, and then grinding the substrate.

In an embodiment of the present invention, the double-sided pressure-sensitive adhesive sheet includes, on at least one surface thereof, a heat-releasable pressure-sensitive adhesive layer.

In an embodiment of the present invention, the double-sided pressure-sensitive adhesive sheet includes a base member and a heat-releasable pressure-sensitive adhesive layer formed on one surface of the base member, and the LED wafer is fixed to the table under a state in which the heat-releasable pressure-sensitive adhesive layer is attached to the LED wafer.

In an embodiment of the present invention, the double-sided pressure-sensitive adhesive sheet includes a base member and a heat-releasable pressure-sensitive adhesive layer formed on one surface of the base member, and the LED wafer is fixed to the table under a state in which the heat-releasable pressure-sensitive adhesive layer is attached to the table.

In an embodiment of the present invention, the double-sided pressure-sensitive adhesive sheet includes a base member and heat-releasable pressure-sensitive adhesive layers formed on both surfaces of the base member.

In an embodiment of the present invention, the LED wafer is fixed to the table under a state in which another pressure-sensitive adhesive sheet is further arranged between the double-sided pressure-sensitive adhesive sheet and the LED wafer.

According to the present invention, in the back-grinding step, after the LED wafer is fixed to the table via the double-sided pressure-sensitive adhesive sheet, the LED wafer is ground. In this manner, the LED wafer may be prevented from being damaged to manufacture the LED with high yields. Further, according to the present invention, wax is unnecessary to fix the LED wafer, and hence application and cleaning of the wax are unnecessary. Therefore, the LED may be simply manufactured. Further, the use of cleaning liquid such as a solvent may be avoided, and hence the LED may be simply manufactured with a small environmental load. Further, an adverse effect to the LED due to the cleaning liquid may be prevented.

### BRIEF DESCRIPTION OF THE DRAWINGS

In the accompanying drawings:
FIGS. **1A** to **1D** are schematic views illustrating a back-grinding step in a method of manufacturing an LED according to an embodiment of the present invention;
FIG. **2** is a schematic sectional view of an LED wafer used in the method of manufacturing an LED according to the embodiment of the present invention;
FIGS. **3A** to **3C** are schematic views illustrating a back-grinding step in a method of manufacturing an LED according to another embodiment of the present invention;
FIGS. **4A** to **4C** are schematic views illustrating a back-grinding step in a method of manufacturing an LED according to still another embodiment of the present invention;
FIGS. **5A** to **5C** are schematic views illustrating a back-grinding step in a method of manufacturing an LED according to further another embodiment of the present invention;
FIGS. **6A** to **6C** are schematic views illustrating a back-grinding step in a method of manufacturing an LED according to yet another embodiment of the present invention;
FIGS. **7A to 7E** are schematic views illustrating respective steps after a back-grinding step in a method of manufacturing an LED according to yet another embodiment of the present invention; and
FIGS. **8A** to **8E** are schematic views illustrating respective steps after a back-grinding step in a method of manufacturing an LED according to yet another embodiment of the present invention.

### DETAILED DESCRIPTION OF THE PREFERRED EMBODIMENTS

### A. Back-grinding Step

A method of manufacturing an LED of the present invention includes a back-grinding step of grinding a substrate of an LED wafer including a light emitting element and the substrate.

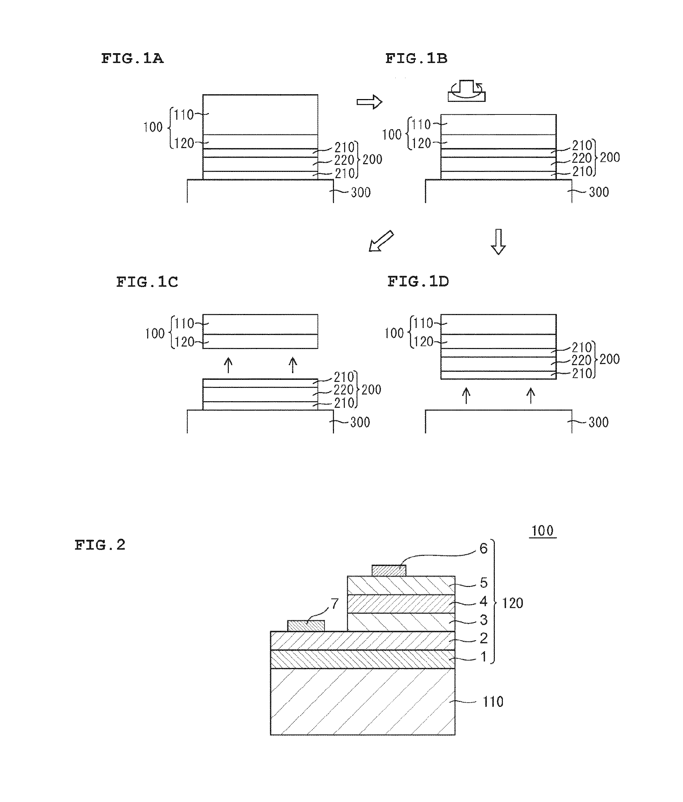

FIGS. **1A** to **1D** are schematic views illustrating a back-grinding step in a method of manufacturing an LED according to an embodiment of the present invention. Further, FIG. **2** is a schematic sectional view of an LED wafer **100.** The LED wafer **100** includes a substrate **110** and a light emitting element **120.** The substrate **110** is made of any appropriate material. Examples of the material for constituting the substrate **110** include sapphire, SiC, GaAs, GaN, and GaP. The effect of the present invention, that is, preventing damage to the LED wafer **100,** is markedly obtained when the employed LED wafer **100** is made of such a hard and brittle material as those materials. The light emitting element **120** includes a buffer layer **1,** an n-type semiconductor layer **2,** a light emitting layer **3,** a p-type semiconductor layer **4,** a transparent electrode **5,** and electrodes **6** and **7.** The light emitting layer **3** includes, for example, gallium nitride-based compounds (e.g., GaN, AlGaN, and InGaN), gallium phosphide-based compounds (e.g., GaP and GaAsP), gallium arsenide-based compounds (e.g., GaAs, AlGaAs, and AlGaInP), and zinc oxide (ZnO)-based compounds. Note that, although not illustrated, the light emitting element **120** may include any other appropriate members.

In the method of manufacturing an LED of the present invention, first, as illustrated in FIG. **1A**, the LED wafer **100** is fixed to a table **300** via a double-sided pressure-sensitive adhesive sheet **200.** At this time, the LED wafer **100** is fixed so that the substrate **110** is directed outward (upward). Subsequently, as illustrated in FIG. **1B**, the substrate **110** of the LED wafer **100** is ground. With this grinding, the substrate **110** can be thinned to a desired thickness. The thickness of the substrate **110** that has undergone grinding is preferably 10 µm to 500 µm, more preferably 50 µm to 300 µm, most preferably 80 µm to 150 µm. Further, the diameter of the employed LED wafer **100** is preferably 2 inches or more, more preferably 3 inches or more, most preferably 4 inches or more. The upper limit of the diameter of the LED wafer **100** is not particularly limited, but in practical use, the diameter is about 12 inches, for example. In the method of manufacturing an LED of the present invention, the double-sided pressure-sensitive adhesive sheet **200** also has function of protecting the LED wafer **100,** and hence the LED wafer **100** may be prevented from being damaged during grinding. Further, the LED wafer **100** can be prevented from being damaged as described above, and hence a large-size (for example, 4 inches or more) LED wafer larger than the conventional one can be handled, and hence the LED can be manufactured with high yields. Subsequently, as illustrated in FIG. **1C** or **1D**, the LED wafer **100** is released from the table **300.** At this time, only the LED wafer **100** may be released from the table **300** while leaving the double-sided pressure-sensitive adhesive sheet **200** on the table **300** (FIG. **1C****),** or the LED wafer with the double-sided pressure-sensitive adhesive sheet may be released from the table **300** (FIG. **1D**). It is preferred that, as illustrated in FIG. **1D**, the LED wafer with the double-sided pressure-sensitive adhesive sheet be released from the table **300.** In this manner, the LED wafer **100** may be prevented from being damaged when the LED wafer **100** is released from the table **300.**

As the double-sided pressure-sensitive adhesive sheet **200,** any appropriate double-sided pressure-sensitive adhesive sheet may be used as long as the effect of the present invention may be obtained. In an embodiment, as illustrated in FIGS. **1A** to **1D**, the employed double-sided pressure-sensitive adhesive sheet **200** includes a base member **220** and pressure-sensitive adhesive layers **210** formed on both surfaces of the base member **220.** As a material for constituting the base member, there may be given, for example: polyolefins such as polyethylene, polypropylene, polybutene, polybutadiene, and polymethylpentene; and polyvinyl chloride, a polyvinyl chloride copolymer, polyethylene terephthalate, polybutylene terephthalate, polyurethane, an ethylene-vinyl acetate copolymer, an ethylene-(meth)acrylic acid copolymer, an ethylene-(meth)acrylate ester copolymer, polystyrene, polycarbonate, polyimide, and a fluorine-based resin. As a form of the base member, there may be given, for example, film, woven fabric, and non-woven fabric. In addition, the base member may be paper or a metal foil. As a material for constituting the pressure-sensitive adhesive layer, there may be given, for example, a rubber-based resin, an acrylic resin, a silicone-based resin, and a polyimide-based resin.

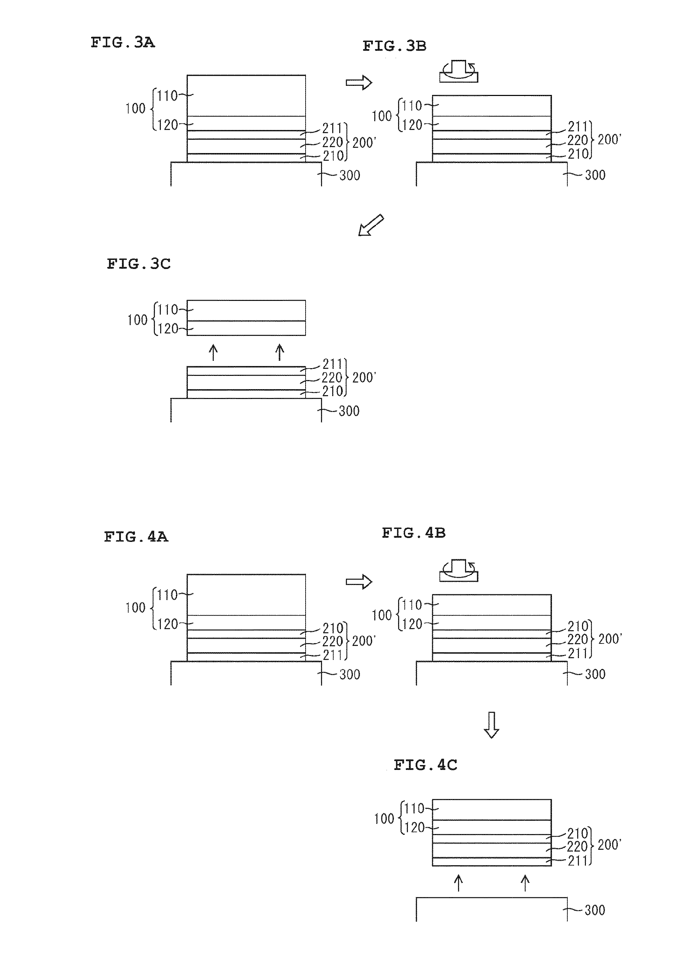

In other embodiments of the present invention, as the double-sided pressure-sensitive adhesive sheet, there is used a double-sided pressure-sensitive adhesive sheet including, on at least one surface thereof, a heat-releasable pressure-sensitive adhesive layer. In this specification, the double-sided pressure-sensitive adhesive sheet including the heat-releasable pressure-sensitive adhesive layer is hereinafter also referred to as "heat-peelable double-sided pressure-sensitive adhesive sheet." The heat-peelable double-sided pressure-sensitive adhesive sheet can be peeled off when the adhesion of the surface of the heat-releasable pressure-sensitive adhesive layer is reduced or lost by heating. With use of the heat-peelable double-sided pressure-sensitive adhesive sheet, the LED wafer is sufficiently fixed during grinding, and after the grinding, the LED wafer can be easily released. As a result, the LED wafer can be prevented from being damaged more markedly. Further, automated steps can be easily designed. As illustrated in FIGS. **3A** to **3C, 4A** to **4C,** and **5A** to **5C,** heat-peelable double-sided pressure-sensitive adhesive sheets **200'** and **200"** each include the base member **220** and a heat-releasable pressure-sensitive adhesive layer **211.** The heat-releasable pressure-sensitive adhesive layer **211** includes, for example, an adhesive or pressure-sensitive adhesive, and a foaming agent. The heat-peelable double-sided pressure-sensitive adhesive sheet **200'** is peeled off when the foaming agent is foamed or expanded by heating. Any appropriate adhesive (pressure-sensitive adhesive) may be used as the adhesive (pressure-sensitive adhesive), and examples thereof include an acrylic adhesive (pressure-sensitive adhesive), a rubber-based adhesive (pressure-sensitive adhesive), and a styrene-conjugated diene block copolymer-based adhesive (pressure-sensitive adhesive). Any appropriate foaming agent may be used as the foaming agent. Examples of the foaming agent include: inorganic foaming agents such as ammonium carbonate, ammonium hydrogen carbonate, sodium hydrogen carbonate, ammonium nitrite, sodium boron hydride, and an azide; and organic foaming agents such as an alkane chloride fluoride, an azo-based compound, a hydrazine-based compound, a semicarbazide-based compound, a triazole-based compound, and an N-nitroso-based compound. Details of such a heat-peelable double-sided pressure-sensitive adhesive sheet are described in Japanese Patent Application Laid-open Nos. Hei 5-043851, Hei 2-305878, and Sho 63-33487, the contents of which are hereby incorporated by reference into this specification.

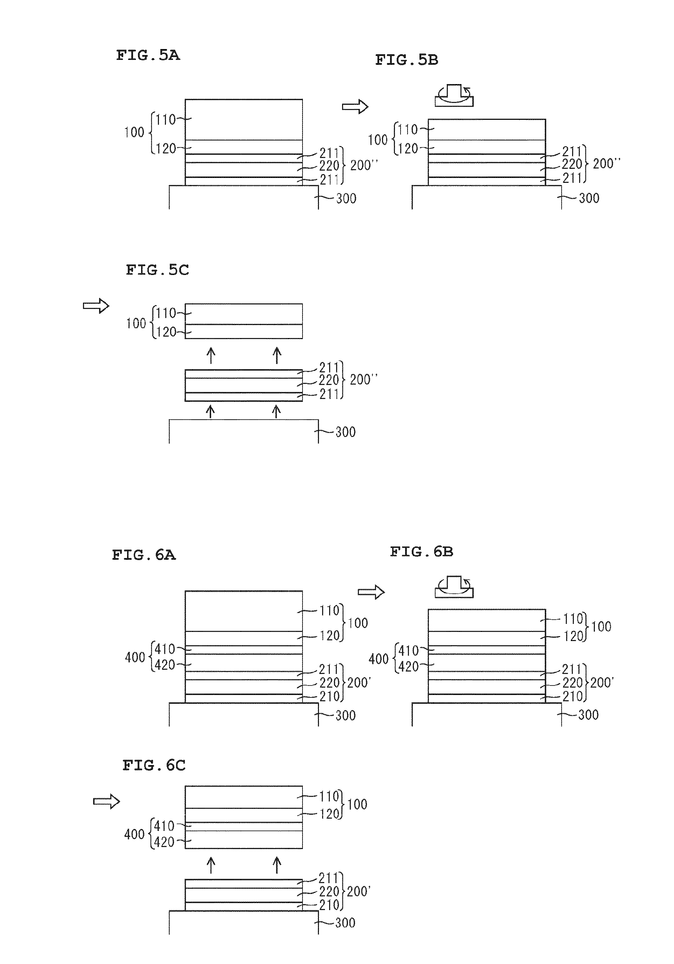

When the heat-peelable double-sided pressure-sensitive adhesive sheet is used as the double-sided pressure-sensitive adhesive sheet, the heat-peelable double-sided pressure-sensitive adhesive sheet may include the heat-releasable pressure-sensitive adhesive layer **211** on one surface of the base member **220** as illustrated in FIGS. **3A** to **3C** and **4A** to **4C,** or may include the heat-releasable pressure-sensitive adhesive layers **211** on both surfaces of the base member **220** as illustrated in FIGS. **5A** to **5C****.**

In the embodiment illustrated in FIGS. **3A** to **3C****,** the heat-peelable double-sided pressure-sensitive adhesive sheet **200'** includes the heat-releasable pressure-sensitive adhesive layer **211** on one surface of the base member **220,** and the LED wafer **100** is fixed to the table **300** under a state in which the heat-releasable pressure-sensitive adhesive layer **211** is attached to the LED wafer **100** (substantially, to the light emitting element **120).** On a surface of the heat-peelable double-sided pressure-sensitive adhesive sheet **200'** on a side opposite to the heat-releasable pressure-sensitive adhesive layer **211** (that is, a surface on the table **300** side), the pressure-sensitive adhesive layer **210** may be provided, and the pressure-sensitive adhesive layer **210** side is attached to the table **300** (FIG. **3A**). In the embodiment illustrated in FIGS. **3A** to **3C****,** the substrate **110** is ground (FIG. **3B**), and after that, heating is performed so that the LED wafer **100** is released from the heat-peelable double-sided pressure-sensitive adhesive sheet **200'** with the surface of the heat-releasable pressure-sensitive adhesive layer as an origin (FIG. **3C****).** According to this embodiment, the LED wafer **100** can be prevented from being damaged during grinding. Further, with one operation (heating), the LED wafer **100** can be released.

In the embodiment illustrated in FIGS. **4A** to **4C****,** the heat-peelable double-sided pressure-sensitive adhesive sheet **200'** includes the heat-releasable pressure-sensitive adhesive layer **211** on one surface of the base member **220,** and the LED wafer **100** is fixed to the table **300** under a state in which the heat-releasable pressure-sensitive adhesive layer **211** is attached to the table **300.** On a surface of the heat-peelable double-sided pressure-sensitive adhesive sheet **200'** on a side opposite to the heat-releasable pressure-sensitive adhesive layer **211** (that is, a surface on the LED wafer **100** side), the pressure-sensitive adhesive layer **210** may be provided, and the pressure-sensitive adhesive layer **210** side is attached to the LED wafer **100** (FIG. **4A****).** In the embodiment illustrated in FIGS. **4A** to **4C****,** the substrate **110** is ground (FIG. **4B**), and after that, heating is performed so that a laminate including the LED wafer **100** and the heat-peelable double-sided pressure-sensitive adhesive sheet **200'** is released from the table **300** with the surface of the heat-releasable pressure-sensitive adhesive layer as an origin (FIG. **4C****).** In this embodiment, after that, the heat-peelable double-sided pressure-sensitive adhesive sheet **200'** is peeled off from the LED wafer **100.** The heat-peelable double-sided pressure-sensitive adhesive sheet **200'** may be peeled off immediately after the back-grinding step, or may be peeled off after performing a predetermined post-process (for example, a reflective layer forming step). According to this embodiment, the LED wafer **100** can be prevented from being damaged during grinding and during handling thereafter, and in addition, it is possible to prevent adhesive residue on the LED wafer **100** after the heat-peelable double-sided pressure-sensitive adhesive sheet **200'** is peeled off.

In the embodiment illustrated in FIGS. **5A** to **5C****,** the heat-peelable double-sided pressure-sensitive adhesive sheet **200"** includes the heat-releasable pressure-sensitive adhesive layer **211** on both surfaces of the base member **220** (FIG. **5A****).** In the embodiment illustrated in FIGS. **5A** to **5C****,** the substrate **110** is ground (FIG. **5B**), and after that, heating is performed so that the LED wafer **100** is released and the heat-peelable double-sided pressure-sensitive adhesive sheet **200"** is peeled off, respectively, with the surface of the heat-releasable pressure-sensitive adhesive layer as an origin (FIG. **5C****).** According to this embodiment, the LED wafer **100** can be prevented from being damaged during grinding. Further, with one operation (heating), the LED wafer **100** can be released. Further, at the same time when the LED wafer **100** is released, the heat-peelable double-sided pressure-sensitive adhesive sheet **200"** can be peeled off from the table **300.** According to this embodiment, a plurality of LED wafers can be continuously and efficiently processed when the plurality of LED wafers are sequentially subjected to the back-grinding step.

Further, according to yet another embodiment of the present invention, as illustrated in FIG. **6A****,** the LED wafer **100** is fixed to the table **300** under a state in which another pressure-sensitive adhesive sheet **400** is further arranged between the heat-peelable double-sided pressure-sensitive adhesive sheet **200'** and the LED wafer **100.** Specifically, the another pressure-sensitive adhesive sheet **400** may be arranged between the heat-releasable pressure-sensitive adhesive layer **211** of the heat-peelable double-sided pressure-sensitive adhesive sheet **200'** and the light emitting element **120** of the LED wafer **100.** In this embodiment, the substrate **110** is ground (FIG. **6B**), and after that, heating is performed so that a laminate including the LED wafer **100** and the another pressure-sensitive adhesive sheet **400** is released from the heat-peelable double-sided pressure-sensitive adhesive sheet **200'** with the surface of the heat-releasable pressure-sensitive adhesive layer as an origin (FIG. **6C**). In this embodiment, after that, the another pressure-sensitive adhesive sheet **400** is peeled off from the LED wafer **100.** The another pressure-sensitive adhesive sheet **400** may be peeled off immediately after the back-grinding step, or may be peeled off after performing a predetermined post-process (for example, the reflective layer forming step). According to this embodiment, the LED wafer **100** can be prevented from being damaged during grinding and during handling thereafter, and in addition, it is possible to prevent adhesive residue on the LED wafer **100.**

As the another pressure-sensitive adhesive sheet **400,** any appropriate pressure-sensitive adhesive sheet may be used. The another pressure-sensitive adhesive sheet **400** includes, for example, a base member **420** and a pressure-sensitive adhesive layer **410** formed on one surface of the base member **420.** As the materials for constituting the base member **420** and the pressure-sensitive adhesive layer **410,** materials similar to those of the double-sided pressure-sensitive adhesive sheet **200** described above may be used.

Note that, referring to FIGS. **6A** to **6C****,** description has been made of the embodiment in which the heat-peelable double-sided pressure-sensitive adhesive sheet **200'** including the heat-releasable pressure-sensitive adhesive layer **211** on one surface of the base member **220** is used. However, it is needless to say that the heat-peelable double-sided pressure-sensitive adhesive sheet **200"** including the heat-releasable pressure-sensitive adhesive layers **211** on both surfaces of the base member **220** may be used.

As described above, in the method of manufacturing an LED of the present invention, wax is unnecessary, which has been conventionally necessary to fix the LED wafer. Therefore, according to the present invention, application and cleaning of the wax are unnecessary, and the LED can be simply manufactured. Further, the use of cleaning liquid such as a solvent may be avoided, and hence the LED may be simply manufactured with a small environmental load. Further, an adverse effect to the LED due to the cleaning liquid may be prevented.

### B. Other Steps (Steps after Back-grinding Step)

The LED wafer **100** that has undergone the back-grinding step, in which the substrate **110** has been ground as described above, is subjected to steps of the post-process including, for example, a step of cutting the LED wafer **100** to singulate small element pieces (dicing step), and a step of forming a reflective layer on the surface of the substrate on the side opposite to the light emitting element (reflective layer forming step).

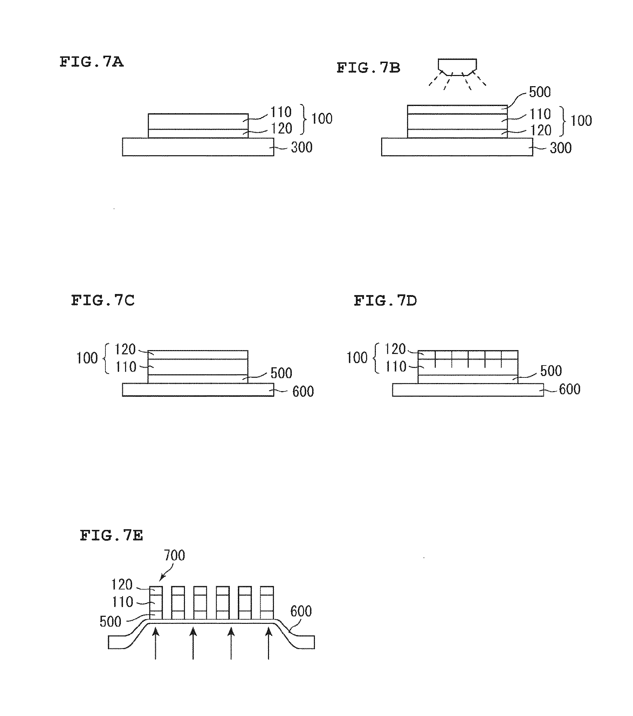

FIGS. **7A** to **7E** are schematic views illustrating respective steps in a method of manufacturing an LED according to yet another embodiment of the present invention.

In this embodiment, as illustrated in FIGS. **7A** and **7B**, the LED wafer **100** that has undergone the back-grinding step, is subjected to the reflective layer forming step. Specifically, the LED wafer **100** is placed on the table **300** with the substrate **110** side of the LED wafer **100** up (FIG. **7A**). After that, a reflective layer **500** is formed on the outer side of the substrate **110** (FIG. **7B**). By forming the reflective layer **500,** the amount of light to be extracted from the light emitting element **120** can be increased. As a material for constituting the reflective layer **500,** any appropriate material may be used as long as the light from the light emitting element **120** may be satisfactorily reflected. Examples of the material for constituting the reflective layer **500** include metals such as aluminum, silver, gold, palladium, platinum, rhodium, and ruthenium. The reflective layer **500** made of a metal may be formed by, for example, a vapor deposition method (for example, a metal organic chemical vapor deposition method (MOCVD method)). It is preferred that an underlayer made of, for example, SiO₂, TiO₂, 2rO₂, and/or MgF₂ be formed on the outer side of the substrate **110** of the LED wafer **100,** and then the reflective layer **500** made of a metal be formed by a vapor deposition method.

After the reflective layer **500** is formed, as illustrated in FIGS. **7C** to **7E****,** the LED wafer **100** having the reflective layer **500** formed thereon is subjected to the dicing step. Specifically, the LED wafer **100** is retained on dicing tape **600** (FIG. **7C**). After that, the LED wafer **100** (substantially, the substrate **110)** is half-cut in the thickness direction (FIG. **7D**). After that, the dicing tape **600** is expanded so that the LED wafer **100** having the reflective layer **500** formed thereon is split from the cut portion as an origin to obtain LEDs **700** singulated into small element pieces (FIG. **7E**).

Referring to FIGS. **7D** and **7E****,** description has been made of the embodiment in which the LED wafer **100** is half-cut so as to split the LED wafer **100** from the cut portion as the origin (scribe dicing). As a method of cutting the LED wafer, in addition to the scribe dicing, any appropriate method may be adopted. Examples of other methods include a method of cutting the LED wafer in the entire thickness direction to singulate the small element pieces through expanding, and a method of laser cutting only the center portion of the LED wafer in the thickness direction to split the LED wafer from the cut portion as an origin (stealth dicing).

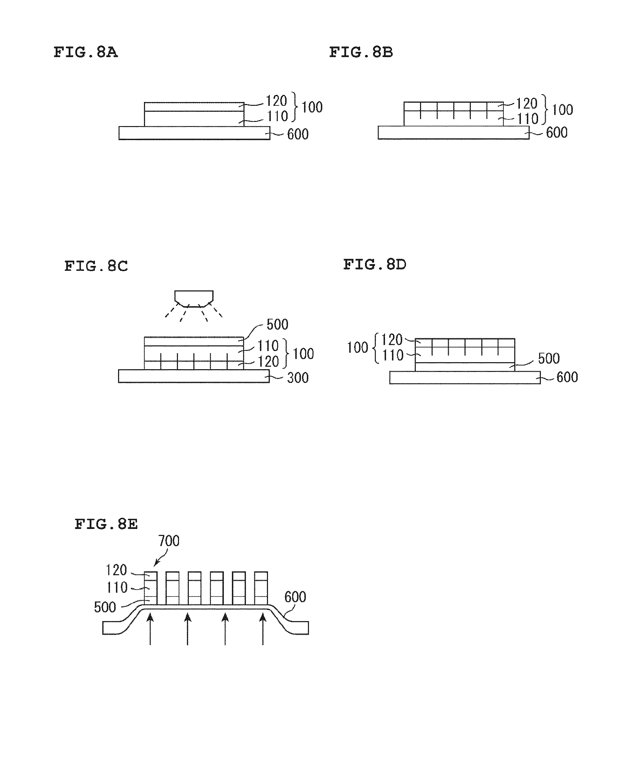

Referring to FIGS. **7A** to **7E**, description has been made of the embodiment in which, prior to the formation of the cut portion for splitting, the reflective layer forming step is performed. The reflective layer forming step may be performed prior to the formation of the cut portion as described above, or may be performed after the cut portion is formed as illustrated in FIGS. **8A** to **8E**. In an embodiment of the present invention illustrated in FIGS. **8A** to **8E**, the LED wafer **100** that has undergone the back-grinding step, is retained on the dicing tape **600** (FIG. **8A****),** and after that, the LED wafer **100** is half-cut (FIG. **8B**). Subsequently, the LED wafer **100** having the cut portion formed therein as described above is subjected to the reflective layer forming step. That is, the LED wafer **100** is placed on the table **300** with the light emitting element **120** side down, and the reflective layer **500** is formed on the substrate **110** side of the LED wafer **100** (FIG. **8C****).** Subsequently, the LED wafer **100** having the reflective layer **500** formed thereon is retained on the dicing tape **600** again with the side on which the cut portion is formed up (FIG. **8D****).** Thus, the LED wafer **100** is split from the cut portion as an origin, to thereby obtain the LEDs **700** singulated into small element pieces (FIG. **8E**).

When the LED wafer that has undergone the back-grinding step includes the double-sided pressure-sensitive adhesive sheet (for example, FIGS. **1D** and **4C****),** in the post-process, the double-sided pressure-sensitive adhesive sheet is peeled off at any appropriate timing. For example, the LED wafer with the double-sided pressure-sensitive adhesive sheet may be retained on dicing tape, and after that, the double-sided pressure-sensitive adhesive sheet may be peeled off. Then, the operations illustrated in FIG. **8A** to **8E** may be performed.

## Claims

1. A method of manufacturing an LED, the method comprising back-grinding a substrate of an LED wafer including a light emitting element and the substrate,
wherein the back-grinding comprises fixing the LED wafer to a table via a double-sided pressure-sensitive adhesive sheet, and then grinding the substrate.

2. A method of manufacturing an LED according to claim 1, wherein the double-sided pressure-sensitive adhesive sheet comprises, on at least one surface thereof, a heat-releasable pressure-sensitive adhesive layer.

3. A method of manufacturing an LED according to claim 2,
wherein the double-sided pressure-sensitive adhesive sheet comprises a base member and a heat-releasable pressure-sensitive adhesive layer formed on one surface of the base member, and
wherein the LED wafer is fixed to the table under a state in which the heat-releasable pressure-sensitive adhesive layer is attached to the LED wafer.

4. A method of manufacturing an LED according to claim 2,
wherein the double-sided pressure-sensitive adhesive sheet comprises a base member and a heat-releasable pressure-sensitive adhesive layer formed on one surface of the base member, and
wherein the LED wafer is fixed to the table under a state in which the heat-releasable pressure-sensitive adhesive layer is attached to the table.

5. A method of manufacturing an LED according to claim 2, wherein the double-sided pressure-sensitive adhesive sheet comprises a base member and heat-releasable pressure-sensitive adhesive layers formed on both surfaces of the base member.

6. A method of manufacturing an LED according to claim 3 or 5, wherein the LED wafer is fixed to the table under a state in which another pressure-sensitive adhesive sheet is further arranged between the double-sided pressure-sensitive adhesive sheet and the LED wafer.
